# EUROPEAN PATENT SPECIFICATION

(11) **EP 1 003 285 B1**
(45) Date of publication and mention of the grant of the patent: **31.08.2005**
(21) Application number: 99122780.2
(22) Date of filing: 16.11.1999
(51) Int. Cl.: H03G 5/16

(54) **Loudness device**
Lautheitsfilter
Filtre d'intensité sonore

(30) Priority: 17.11.1998 JP 32652998
(43) Date of publication of application: 24.05.2000
(73) Proprietor: Pioneer Corporation, Tokyo (JP)
(72) Inventor: Kageyama, Toru, c/o Pioneer Corporation, Kawagoe-shi, Saitama 350-0822 (JP); Takami,Yusuke, c/o Pioneer Corporation, Kawagoe-shi, Saitama 350-0822 (JP); Sasaki, Masaru, c/o Pioneer Corporation, Kawagoe-shi, Saitama 350-0822 (JP); Inohana, Haruyuki, c/o Pioneer Corporation, Kawagoe-shi, Saitama 350-0822 (JP); Sawaki, Manabu, c/o Pioneer Corporation, Kawagoe-shi, Saitama 350-0822 (JP)
(74) Representative: Grünecker, Kinkeldey, Stockmair & Schwanhäusser Anwaltssozietät

(56) References cited:
- US-A- 4 710 962
- US-A- 5 172 358
- PATENT ABSTRACTS OF JAPAN vol. 014, no. 524 (E-1003), 16 November 1990 (1990-11-16) -& JP 02 222207 A (MATSUSHITA ELECTRIC IND CO LTD), 5 September 1990 (1990-09-05)
- ARTHUR R. NEWCOMB, RICHARD N. YOUNG: "Practical Loudness: An Active Circuit Design Approach" JOURNAL OF THE AUDIO ENGINEERING SOCIETY, vol. 24, no. 1, January 1976 (1976-01), pages 32-35, XP009015234 USA
- TSENG C. LIAO: "Tunable loudness control" ELECTRONICS WORLD AND WIRELESS WORLD, vol. 95, no. 1640, 1 June 1989 (1989-06-01), page 576 XP000210078 Sutton, Surrey, GB

## Description

### BACKGROUND OF THE INVENTION

### 1. Field of the Invention

The present invention relates to a loudness device used in an audio signal processing system.

### 2. Description of the Related Art

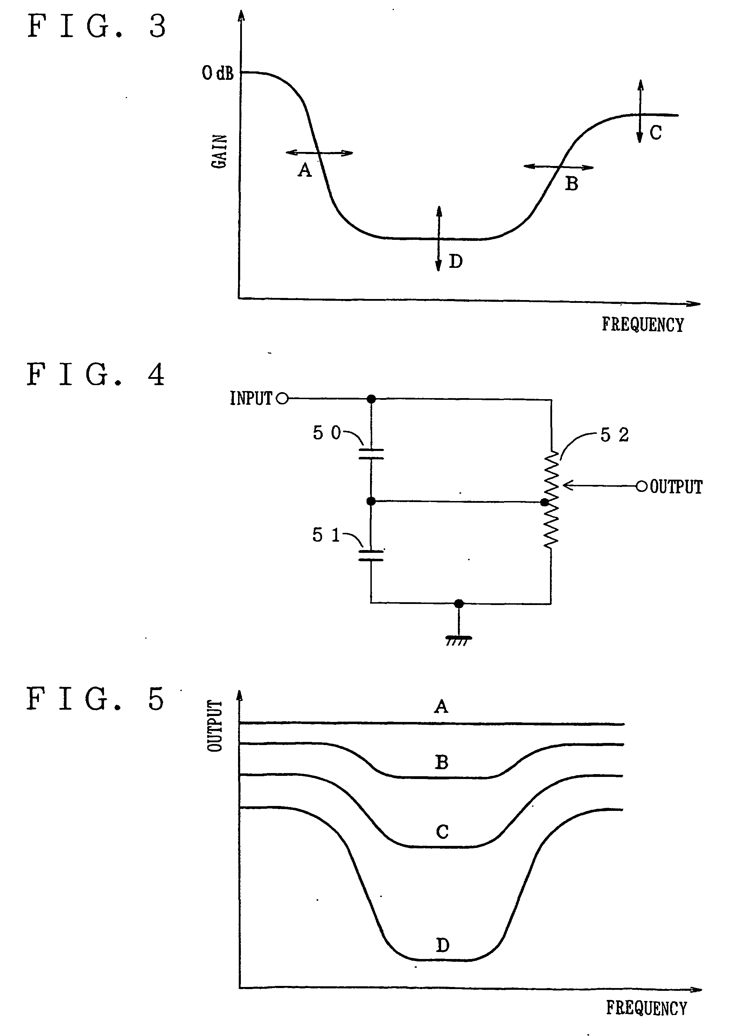

As shown in Fig. 4, a conventional loudness device is composed of a series connection of capacitors 50 and 51 and a variable resistor 52 which are connected in parallel for an input. The connecting point between the capacitors 50 and 51 and the middle point in resistance of the variable resistor 52 are connected to each other. An output is obtained from a sliding piece of the variable resistor 52.

Fig. 5 is a graph showing the characteristic when the sliding piece of the variable resistor 52 in the loudness device as shown in Fig. 4 is shifted.

In Fig. 5, line A indicates the characteristic when the sliding piece has been shifted to the maximum toward the input terminal. In this case, an input signal is outputted as it is.

When the sliding piece is shifted toward the side of grounding, as indicated by line B in Fig. 5, both low frequency and high frequency ranges attenuate. In addition, the intermediate frequency range attenuates more greatly.

When the sliding piece is further shifted toward the grounding side, as indicated by lines C and D, the intermediate frequency range attenuates further more greatly than both low frequency and high frequency ranges.

In the conventional loudness device, as shown in Fig. 4, the characteristic in each of both low frequency and high frequency ranges is uniquely defined according to setting the attenuation degree in the intermediate range. Therefore, a user cannot control the loudness to the most preferable characteristic.

Document Patent Abstracts of Japan JP 02 222207 describes a hearing sense compensation device having fixed cut-off frequencies. It comprises a low pass filter and a high pass filter in order to derive a low frequency band and a high frequency band of the input signal, a first synthesizer having a fixed synthesizing rate to mix the output signals from the low and high pass filter, and a second synthesizer for synthesizing the input signal and the output of the first synthesizer at a variable synthesizing rate.

### SUMMARY OF THE INVENTION

An object of the present invention is to provide a loudness device which can vary the attenuation degree of an intermediate frequency band, cutoff frequency of a low frequency pass-band, cutoff frequency of a high frequency pass-band, and attenuation degree of the high frequency pass-band.

In order to attain the above object of the present invention, in accordance with the present invention, there is provided a loudness device comprising: a low-pass filter (LPF) which has a variable cut-off frequency and passes a low frequency band of an input signal; a high-pass filter (HPF) which has a variable cut-off frequency and passes a high frequency band of the input signal; a first synthesizer for synthesizing output signals from the LPF and HPF at a variable synthesizing rate to provide a first synthesized output; and a second synthesizer for synthesizing the input signal and an output from the first synthesizer at a variable synthesizing rate to provide a second synthesized output.

In this configuration, the loudness device can vary the attenuation degree of an intermediate frequency band, cutoff frequency of a low-pass frequency band, cutoff frequency of a high-pass frequency band, and attenuation degree of the high -pass frequency band.

Preferably, the second synthesizer is a sliding resistor having end terminals to which the input signal and the output signal from the first synthesizer are supplied, respectively and a sliding terminal from which the synthesized output is produced. In this configuration, the attenuation degree of the intermediate frequency band can be easily varied by shifting the position of the sliding terminal.

Preferably, the first synthesizer includes an operational amplifier, a first fixed resistor through which the output signal from the LPF is connected, a variable resistor through which the output signal from the HPF is connected, and a second fixed resistor having a resistance equal to that of the first fixed resistor, through which an output from the operational amplifier is fed back to an input thereof. In this configuration, the attenuation degree of the high-pass frequency band can be easily varied by varying the resistance of the variable resistor.

The above and other objects and features of the present invention will be more apparent from the following description taken in conjunction with the accompanying drawings.

### BRIEF DESCRIPTION OF THE DRAWINGS

Fig. 1 is a schematic circuit diagram of an embodiment of a loudness device according to the present invention;
Fig. 2 is a concrete circuit diagram of a filter block in the embodiment of the loudness device;
Fig. 3 is a graph for explaining the operation of the loudness device;
Fig. 4 is a schematic circuit diagram of a conventional loudness device; and
Fig. 5 is a graph showing the characteristic of the conventional loudness device.

### DESCRIPTION OF THE PREFERRED EMBODIMENT

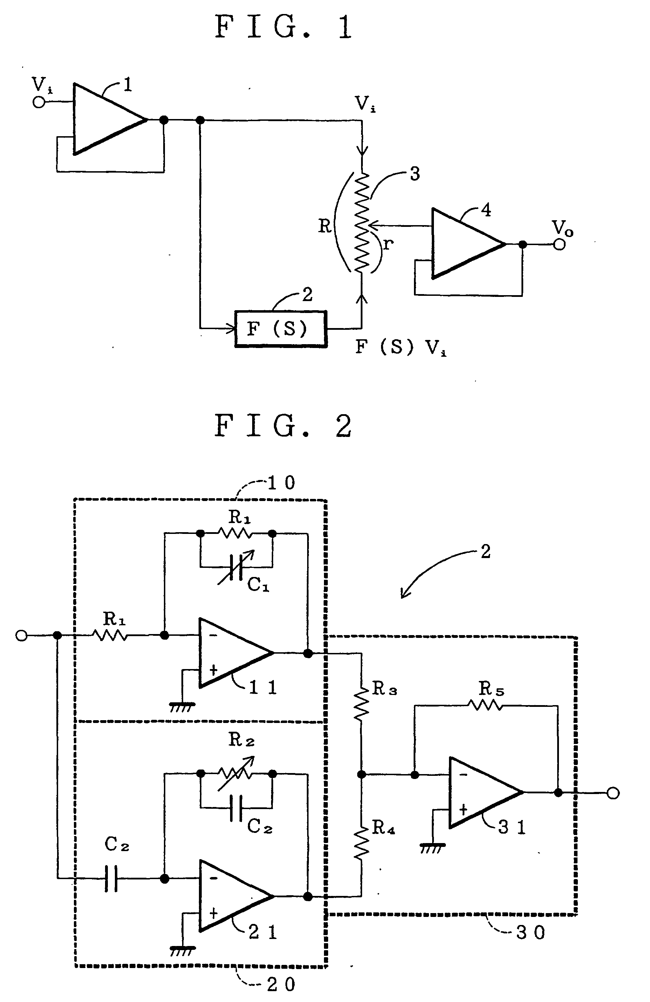

Now referring to Figs. 1 and 2, an explanation will be given of an embodiment of the loudness device according to the present invention. Fig. 1 is a schematic circuit diagram of an embodiment of a loudness device according to the present invention. Fig. 2 is a concrete circuit diagram of a filter block in the embodiment of the loudness device.

In Fig. 1, reference numeral 1 denotes a buffer amplifier; 2 a filter block; 3 a second synthesizer for synthesizing an input signal and a filter block output; and 4 a buffer amplifier.

The second synthesizer 3 includes a sliding resistor, to both ends of which an input signal (Vi) and an output signal (F(s)Vi) from the filter block 2 are supplied. An output signal is produced from a sliding terminal of the sliding resistor, and supplied to the buffer amplifier 4.

The filter block 2, as shown in Fig. 2, a low-pass filter (LPF) 10, a high-pass filter (HPF) 20 and a first synthesizer 30.

In the low-pass filter (LPF) 10, the input signal is supplied to an operational amplifier 11 through a resistor R1, and an output from the operational amplifier 11 is fed back to the input thereof through a parallel circuit composed of a resistor R1 and capacitor C1. Therefore, the low-pass filter (LPF) 10 serves as a first order low-pass filter having a time constant of the values of the resistor R1 and capacitor C1.

The cut-off frequency of the low-pass filter 10 can be varied by the capacitance of the capacitor C1.

In the high-pass filter (LPF) 20, the input signal is supplied to an operational amplifier 21 through a capacitor C2, and an output from the operational amplifier 21 is fed back to the input thereof through a parallel circuit composed of a resistor R2 and capacitor C2. Therefore, the high-pass filter (LPF) 20 serves as a first order high-pass filter having a time constant of the values of the resistor R2 and capacitor C2. The cut-off frequency of the high-pass filter 20 can be varied by varying the resistance of the resistor R2.

In the first synthesizer 30, the output from the low-pass filter 10 is supplied to an operational amplifier 31 through a resistor R3, the output from the high-pass filter 20 is also supplied to the operational amplifier 31 through a resistor R4, and the output from the operational amplifier 31 is fed back to the input thereof though a resistor R5 having a resistance equal to that of the resistor R3.

Thus, the low-pass frequency band can be varied by varying the capacitance of the capacitor C1 of the LPF 10 ("A" in Fig. 3), the high-pass frequency band can be varied by the resistance of the resistor R2 of the HPF 20 ("B" in Fig. 3), the attenuation degree in the high-pass frequency band can be varied by varying the resistance of the resistor R4 ("C" in Fig. 3) of the first synthesizer 30, and the attenuation degree of the intermediate frequency band can be varied by shifting the sliding position (γ/R) of the sliding terminal of the second synthesizer 3 ("D" in Fig. 3).

## Claims

1. A loudness device with adjustable frequency characteristic including:
a low pass filter (10) which passes a low frequency band of an input signal,
a high pass filter (20) which passes a high frequency band of the input signal,
a first synthesizer (30) for synthesizing the output signals from the low pass filter (10) and the high pass filter (20), and
a second synthesizer (3) for synthesizing the input signal and the output signal from the first synthesizer (30) to provide a synthesized output, said second synthesizer (3) being adapted to provide for a variable attenuation of the intermediate frequency band;
**characterized in that**
the cut-off frequency of the low pass filter (10) and the cut-off frequency of the high pass filter (20) are adjustable, and
the first synthesizer (30) is adapted to provide for a variable attenuation of the high-pass frequency band.

2. The loudness device according to claim 1, wherein said second synthesizer (3) is a sliding resistor having a sliding terminal from which said, synthesized output is collected, and the sliding resistor being supplied at one end with said input signal and at the other end with said output signal from the first synthesizer (30).

3. The loudness device according to claim 1 or 2, wherein said first synthesizer (30) includes:
an operational amplifier (31),
a first fixed resistor through which said output signal from said low-pass filter (10) is connected,
a variable resistor through which said output signal from said high-pass filter (20) is connected, and
a second fixed resistor having a resistance equal to that of said first fixed resistor, through which an output from said operational amplifier (31) is fed back to an input thereof.

## Patentansprüche

1. Lautstärkevorrichtung mit einstellbarer Frequenzkennlinie, die enthält:
ein Tiefpassfilter (10), das ein Tieffrequenzband eines Eingangssignals durchlässt,
ein Hochpassfilter (20), das ein Hochfrequenzband des Eingangssignals durchlässt,
einen ersten Synthesizer (30), der die Ausgangssignale von dem Tiefpassfilter (10) und dem Hochpassfilter (20) synthetisiert, und
einen zweiten Synthesizer (3), der das Eingangssignal und das Ausgangssignal von dem ersten Synthesizer (30) synthetisiert, um einen synthetisierten Ausgang zu erzeugen, wobei der zweite Synthesizer (3) so eingerichtet ist, dass er eine veränderliche Dämpfung des Zwischenfrequenzbandes vorsieht;
**dadurch gekennzeichnet, dass**:
die Grenzfrequenz des Tiefpassfilters (10) und die Grenzfrequenz des Hochpassfilters (20) einstellbar sind,
der erste Synthesizer (30) so eingerichtet ist, dass er eine veränderliche Dämpfung des Hochpass-Frequenzbandes vorsieht.

2. Lautstärkevorrichtung nach Anspruch 1, wobei der zweite Synthesizer (3) ein Gleitwiderstand ist, der einen Gleitanschluss hat, von dem der synthetisierte Ausgang abgenommen wird, und der Gleitwiderstand an einem Ende mit dem Eingangssignal und am anderen Ende mit dem Ausgangssignal von dem ersten Synthesizer (30) gespeist wird.

3. Lautstärkevorrichtung nach Anspruch 1 oder 2, wobei der erste Synthesizer (30) enthält:
einen Operationsverstärker (31),
einen ersten Festwiderstand, über den das Ausgangssignal von dem Tiefpassfilter (10) geschaltet wird,
einen Regelwiderstand, über den das Ausgangssignal von dem Hochpassfilter (20) geschaltet wird, und
einen zweiten Festwiderstand, der einen Widerstandswert hat, der dem des ersten Festwiderstandes gleich ist und über den ein Ausgang von dem Operationsverstärker (31) zu einem Eingang desselben zurückgeführt wird.

## Revendications

1. Dispositif d'intensité sonore à caractéristique fréquentielle ajustable, incluant :
un filtre passe-bas (10) qui laisse passer une bande de basses fréquences d'un signal d'entrée,
un filtre passe-haut (20) qui laisse passer une bande de hautes fréquences du signal d'entrée,
un premier synthétiseur (30) pour synthétiser les signaux de sortie provenant du filtre passe-bas (10) et du filtre passe-haut (20), et
un second synthétiseur (3) pour synthétiser le signal d'entrée et le signal de sortie provenant du premier synthétiseur (30) de manière à délivrer un signal de sortie synthétisé, ledit second synthétiseur (3) étant conçu pour assurer une atténuation variable de la bande de fréquences intermédiaires ;
**caractérisé en ce que**
la fréquence de coupure du filtre passe-bas (10) et la fréquence de coupure du filtre passe-haut (20) sont ajustables,
le premier synthétiseur (30) est conçu pour assurer une atténuation variable de la bande de hautes fréquences.

2. Dispositif d'intensité sonore selon la revendication 1, dans lequel ledit second synthétiseur (3) est une résistance réglable pourvue d'une borne réglable à partir de laquelle est collecté ledit signal de sortie synthétisé, la résistance réglable recevant, à une première borne, ledit signal d'entrée et, à l'autre borne, ledit signal de sortie provenant du premier synthétiseur (30).

3. Dispositif d'intensité sonore selon la revendication 1 ou 2, dans lequel ledit premier synthétiseur (30) inclut :
un amplificateur opérationnel (31),
une première résistance fixe à travers laquelle est connecté ledit signal de sortie provenant dudit filtre passe-bas (10),
une résistance variable à travers laquelle est connecté ledit signal de sortie provenant dudit filtre passe-haut (20), et
une seconde résistance fixe ayant une valeur de résistance égale à celle de ladite première résistance fixe, à travers laquelle est réinjecté, à son entrée, un signal de sortie provenant dudit amplificateur opérationnel (31).
